(19) Europäisches Patentamt / European Patent Office / Office européen des brevets

(11) **EP 2 177 487 B1**

(12) **EUROPEAN PATENT SPECIFICATION**

(45) Date of publication and mention
of the grant of the patent:
**28.12.2011 Bulletin 2011/52**

(51) Int Cl.:
**C03C 23/00** (2006.01)    **C03C 15/00** (2006.01)
**C03C 15/02** (2006.01)    **G03F 1/14** (2011.01)
**H01L 21/027** (2006.01)

(21) Application number: **07792598.0**

(22) Date of filing: **16.08.2007**

(86) International application number:
**PCT/JP2007/065968**

(87) International publication number:
**WO 2009/022428 (19.02.2009 Gazette 2009/08)**

(54) **METHOD OF REMOVING CONTAMINANT FROM SURFACE OF GLASS SUBSTRATE**

VERFAHREN ZUR ENTFERNUNG VON OBERFLÄCHENVERUNREINIGUNGEN AUF EINEM GLASSUBSTRATS

PROCÉDÉ D'ÉLIMINATION DE CONTAMINANTS SUR LA SURFACE D'UN SUBSTRAT EN VERRE

(84) Designated Contracting States:
**AT BE BG CH CY CZ DE DK EE ES FI FR GB GR
HU IE IS IT LI LT LU LV MC MT NL PL PT RO SE
SI SK TR**

(43) Date of publication of application:
**21.04.2010 Bulletin 2010/16**

(73) Proprietor: **Asahi Glass Company, Limited
Chiyoda-ku
Tokyo 100-8405 (JP)**

(72) Inventor: **IKUTA, Yoshiaki
Tokyo 100-8405 (JP)**

(74) Representative: **Müller-Boré & Partner
Patentanwälte
Grafinger Straße 2
81671 München (DE)**

(56) References cited:
JP-A- 05 015 474       JP-A- 07 256 473
JP-A- 2004 359 475    JP-A- 2007 069 216
JP-A- 2007 072 121    US-A1- 2007 012 335
US-A1- 2007 013 892   US-A1- 2007 163 715

• KAPILA V ET AL: "Cleaning of MoSi multilayer mask blanks for EUVL", 2006, PROCEEDINGS OF SPIE - THE INTERNATIONAL SOCIETY FOR OPTICAL ENGINEERING - PHOTOMASK TECHNOLOGY 2006 2006 SPIE US, VOL. 6349 I, XP002629832, * the whole document *
• HUA M ET AL: "Limit analysis for laser removal of micron contaminant colloidal silicon dioxide particles from the super-smooth optical glass substrate by pulse Nd:YAG laser", OPTICS AND LASER TECHNOLOGY, ELSEVIER SCIENCE PUBLISHERS BV., AMSTERDAM, NL, vol. 37, no. 1, 1 February 2005 (2005-02-01), pages 9-20, XP004551042, ISSN: 0030-3992

**Description**

The present invention relates to a method for removing a contaminant adhered to a surface of a glass substrate. Particularly, it relates to a method for removing an inorganic contaminant firmly adhered to a glass substrate surface, which can hardly be removed by a conventional wet cleaning. Here, a contaminant adhered to a substrate which can hardly be removed by a conventional wet cleaning may, for example, be a contaminant composed of an inorganic substance (such as silicon oxide, aluminum oxide or silicon nitride) or a fluorinated organic compound (such as PFA, PTFE, ETCFE or ETFE) which is excellent in chemical stability and can hardly be dissolved to be removed by a method such as oxidation or reduction, a contaminant adhered to the substrate surface with a relatively large contact area and having a low height, or a fibrous contaminant.

With the continuous progress of semiconductor devices, a strong demand is present in semiconductor fabrication process for removing nanoparticles of smaller than 100 nm. Wet-etching employing an etchant is an method which has heretofore been used to remove a contaminant such as nanoparticles from a surface of a glass substrate for a photomask (substrate material: quartz glass containing $SiO_2$ as the main component, such as synthetic quartz glass or synthetic Ti-doped quartz glass, or glass ceramics having a low thermal expansion coefficient) or from a surface of a $SiO_2$ layer of a Si wafer.

A contaminant present on a glass substrate surface is adhered to the glass substrate surface mainly by van der Waals attraction. In a case where a contaminant is adhered to a glass substrate surface, the distance between the contaminant and the substrate surface is less than 0.4 nm. A few methods are available as methods to remove a contaminant adhered to a surface, as follows.

(1) A method to remove a contaminant by applying a mechanical force, such as highly pressurized water, $CO_2$ aerosol cleaning, argon aerosol cleaning or brush cleaning.

(2) A method to etch and dissolve a contaminant itself by utilizing a difference in the etching rate between the substrate and the contaminant (i.e. by utilizing a reagent which etches the contaminant at a large etch rate as compared to an etch rate of the substrate). For example, in the case of a contaminant composed of an organic substance, a method for removing it by oxidation decomposition by ozonated water, and in the case of a contaminant made of metal, a method for removing it by ionizing it by an oxidizing solution such as an aqueous hydrochloric solution or nitric acid.

(3) A method for slightly wet-etching the substrate surface. This method is a so-called lift off method and is a method for removing a contaminant from the substrate surface by etching the entire substrate surface so that the contaminant is detached off from the substrate surface at a distance of at least 0.4 nm which is the minimum value distance where the van der Waals attraction no longer works. As an etchant to be used for such wet-etching, aqueous ammonia ($NH_4OH$) or hydrofluoric acid (HF) may, for example, be employed.

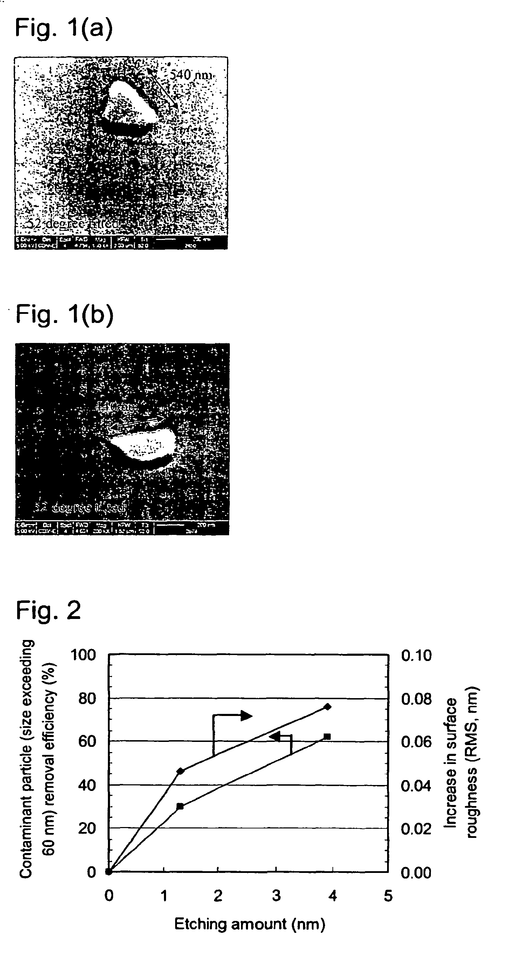

However, in the case of contaminants, having a large contact area with the glass substrate surface, like contaminants shown in Figs. 1 (a) and 1 (b) or contaminants, composed of a material with an excellent chemical stability, it has been difficult to remove them by the above mentioned conventional cleaning methods. Figs. 1(a) and 1(b) are SEM photographs showing the vicinity of the portions where contaminants are present on surfaces of quartz glass substrates, and the SEM photographs were taken with a tilt angle of 52° to show how the contaminants adhere to the substrate surface. By the energy dispersive X-ray spectroscopy, the main constituting component of the contaminants shown in Figs. 1(a) and 1(b) is confirmed to be $SiO_2$. Such a contaminant has a large contact area with the glass substrate surface, and the van der Waals attraction between the contaminant and the glass substrate surface is accordingly large, whereby the contaminant is firmly adhered on the glass substrate surface, and further, the height is low, whereby removal by a mechanical force (the above-mentioned method (1)) is difficult. And since the composition is the same as the substrate, the above-mentioned method (2) is also difficult. Further, by the above-mentioned method (3), since the contact area with the glass substrate surface is large, in order to peel off the contaminant from the substrate surface, it is required to etch the substrate surface with large amount by an etching for a longer period of time or by an etchant with a higher concentration.

Fig. 2 is a graph showing the efficiency (%) for removal of contaminant particles having sizes exceeding 60 nm and the increase in surface roughness (RMS, nm) of the substrate, against the etching amount (nm), when a quartz glass plate was subjected to wet-etching with a 0.2 wt% HF solution. Firstly, the sizes and locations of the contaminant particles on the quartz glass substrate and the surface roughness (RMS, nm) before wet etching are determined respectively by a defect inspection tool and AFM. Then, using a 0.2 wt% HF solution, wet-etching is carried out for a predetermined time, and again, the sizes and locations (coordinate) of the contaminant on the substrate and the surface roughness are determined. The contaminant not removed by the wet-etching can be identified by comparing the positional information of the contaminant obtained before and after the wet-etching, and the contaminant removal rate (%) can be obtained by the following formula:

Contaminant removal rate (%)

= {1-(number of contaminant not removed by cleaning/number of contaminant before cleaning)}×100(%)

Further, from the change in the surface roughness (RMS, nm) of the substrate before and after the wet-etching, the increase of the surface roughness (RMS, nm) of the substrate can be obtained.

As is evident from Fig. 2, the contaminant removal rate becomes high when the substrate surface is etched more but, at the same time, the surface roughness of the substrate increases. Namely, wet-etching not only removes contaminants from the substrate surface but also causes the increase in the surface roughness of the substrate.

In the case of a glass substrate for a photomask, an increase in the surface roughness of the substrate increases a scattering loss of irradiation light, whereby the transmittance will decrease in the case of an optical lithography mask employing a light transmission type mask. In the case of an extreme ultraviolet (EUV) lithography mask employing a light reflective mask, not only the reflectance decreases, but also a flare is likely to be caused at the time of the exposure, such being problematic. In addition, the sharpness of the edges of a pattern formed on the photomask substrate surface is thereby decreased, and when exposed and transferred to the photoresist layer on a Si wafer, the pattern on the photoresist layer after development will have degraded edge sharpness likewise, thus leading to a problem of so-called edge roughness. Therefore, the surface roughness of a glass substrate for a lithography mask is required to be as low as possible. The requirement for lower surface roughness becomes severer as the wavelength of light to be used for lithography shifts towards a shorter wavelength side. For example, in the case of a glass substrate for an EUV lithography mask where extreme ultraviolet light having a wavelength of from 13 to 14 nm is employed, the surface roughness is required to be less than 0.15 nm by RMS. Accordingly, in order to prevent an adverse effect on a lithography process, it becomes necessary to minimize the etching amount of the glass substrate for lithography at the time of cleaning to remove a contaminant thereby to prevent an increase of the surface roughness.

V. Kapila et al. (Proceedings of SPIE - The International Society for Optical Engineering - Photomask Technology 2006, Vol. 6349 I) describe the cleaning of MoSi multilayer mask blanks for EUVL.

US 2007/0013892 A1 discloses an exposure apparatus for exposing a pattern of a mask onto a plate to be exposed.

US 2007/0163715 A1 discloses apparatuses and methods for cleaning a surface comprising contaminate particles.

US 2007/0012335 A1 discloses a multi-step cleaning procedure which cleans phase shift photo-masks and other photomasks and Mo-containing surfaces.

M. Hua et al. (Optics and Laser Technology, Elsevier Science, 2004, Vol. 37, 9-20) describe limit analysis for laser removal of micron contaminant colloidal silicon dioxide particles from the super-smooth optical glass substrate by a pulse Nd:YAG laser.

In order to solve the above-mentioned problems of the prior art, it is an object of the present invention to provide a novel method for removing a contaminant (hard defect) firmly adhered to the surface of a glass substrate without increasing the surface roughness of the glass substrate over the entire surface of the substrate.

In order to accomplish the above object, the present invention provides a method for removing a contaminant from a surface of a glass substrate (herein referred to as "the contaminant removal method of the present invention"), which comprises a step of irradiating a portion of the glass substrate surface where the contaminant is present, with at least one type of high energy beams selected from the group consisting of laser beams having a wavelength of at most 350 nm, X-rays, electron beams, neutron beams and γ-rays, to induce a stress due to a structural change of constituting material of the glass substrate at the portion irradiated with the high energy beams, and a step of wet-etching the glass substrate surface after the irradiation with the high energy beams.

The etchant to be used in the step of wet-etching the glass substrate surface is not particularly limited and any etchant may be used so long as it is one for etching glass. However, it particularly preferably contains at least one member selected from the group consisting of an aqueous hydrogen fluoride (HF) solution, an aqueous ammonium fluoride ($NH_4F$) solution, an aqueous ammonia ($NH_4OH$) solution, an aqueous potassium hydroxide (KOH) solution and an aqueous sodium hydroxide (NaOH) solution.

Further, the glass substrate may, for example, be made of a glass selected from the group consisting of alkali-free glass, fused quartz glass, synthetic quartz glass, Ti-doped quartz glass and low thermal expansion glass ceramics.

Further, the contaminant removal method of the present invention is preferably such that before carrying out the step (the high energy beam irradiation step) of irradiating a portion of the glass substrate surface where the contaminant is present with high energy beams to induce a stress due to a structural change of constituting material of the glass substrate at the portion irradiated with the high energy beams, a step of determining the portion of the glass substrate surface where the contaminant is present, and the size thereof, is provided, and the irradiation with the high energy beams in the high energy beam irradiation step, is applied to the portion where the contaminant is present, as determined in such a step.

Further, the method according to the present invention provides a glass substrate to be used for a reflective mask for EUV lithography by removing a contaminant from a surface of a glass substrate as defined above, which has substantially no defects having a contaminant with a size exceeding from 20 to 30 nm on the surface and has a surface roughness of at most 0.15 nm (RMS).

According to the contaminant removal method of the present invention, it is possible to efficiently remove a contaminant from a glass substrate surface without increasing the surface roughness of the glass substrate over the entire surface of the substrate.

Figs. 1 (a) and 1 (b) are SEM photographs each showing the vicinity of the portion of quartz glass substrate surface where contaminant is present.

Fig. 2 is a graph showing the relation between the etching amount (nm), and the efficiency (%) for removal of contaminant having sizes exceeding 60 nm and the increase in the surface roughness (RMS, nm) of the substrate, when a quartz glass plate was subjected to wet-etching step using a 0.2 wt% HF solution.

Fig. 3 is a flowchart of a conventional process for wet-cleaning.

The contaminant removal method of the present invention comprises the following two steps:

(1) A step of irradiating a portion of the glass substrate surface where the contaminant is present with high energy beams, to induce a stress due to a structural change of constituting material of the glass substrate at the portion irradiated with the high energy beams.
(2) A step of wet-etching the glass substrate surface after irradiation with the high energy beams.

Firstly, the above step (1) will be described.

It is known that when glass is irradiated with high energy beams, volume compaction and/or volume expansion of the glass will take place at the portion irradiated with the high energy beams, and a high internal stress will be induced in the vicinity of such a portion. With respect to such a phenomenon, its detailed mechanism has not yet been clearly understood. In the following, a plausible mechanism is shown in the case where quartz glass is irradiated with high energy beams.

Quartz glass has network structures. The majority of the network structures are 6-membered ring structures. In such a state, the Si-O-Si angle of a network structure is most stable and Si-O bond in 6-membered ring structure has no strain. However, a part of such a network structure has its Si-O-Si angle slightly shifted towards the angle of small ring structure such as 3-membered or 4-membered ring structure and thus Si-O bond has a strain. When quartz glass is irradiated with high energy beams, the structure having a strain will be preferentially dissociated and re-associated to form a structure having small strain. Such a change in the ring structure is accompanied with a volume change of quartz glass constituting the portion i.e. volume compaction or volume expansion. As a result, in the vicinity of the portion of the quartz glass irradiated with the high energy beams, a high internal stress will be induced by a structural change (volume change) of the constituting material of the glass substrate.

Now, the above step (2) will be described. In the step (2), the entire surface of the glass substrate after carrying out the step (1) is subjected to wet-etching. It is known that when the surface of a glass substrate is subjected to wet-etching, the etching rate varies depending upon the presence or absence of the internal stress of the glass substrate. Specifically, at a portion where the internal stress is present, the etching rate becomes higher than at the portion where no internal stress is present.

In the glass substrate after carrying out the step (1), in the vicinity of the portion of the glass substrate surface where a contaminant is present, a stress induced by a structural change of constituting material of the glass substrate due to irradiation with high energy beams, is present. Accordingly, when the surface of the glass substrate after carrying out the step (1) is subjected to wet-etching, in the vicinity of the portion irradiated with the high energy beams in the step (1), the etching rate becomes higher than at other portions (non-irradiated portions) of the glass substrate surface not irradiated with the high energy beams.

In other words, in the method of the present invention, by irradiating the glass substrate surface with the high energy beams in the step (1), the etching rate in the wet-etching carried out in the step (2) can be locally increased. Therefore, according to the present invention, when the entire glass substrate is exposed to a prescribed etchant, only the vicinity of the portion where a contaminant is present can be etched relatively more without etching the entire surface of the glass substrate substantially, whereby the contaminant present on the glass substrate surface can efficiently be removed without increasing the surface roughness of the substrate over the entire surface of the substrate.

The method of the present invention for removing a contaminant from the glass substrate surface is applicable not only to quartz glass, but also to glass, such as alkali-free glass (such as borosilicate glass), fused quartz glass, synthetic quartz glass, Ti-doped quartz glass or low thermal expansion glass ceramics. The method of the present invention for removing a contaminant from the glass substrate surface is particularly preferably applicable to a glass substrate for a photomask, excellent in the dimensional stability (the linear thermal expansion coefficient being at most $\pm 1 \times 10^{-7}$/K) and required to have a contaminant on the substrate surface as few as possible and to have a low surface roughness.

The high energy beams to be used in the present invention are not particularly limited so long as they are able to induce a structural change of material constituting the glass substrate, e.g. a volume change such as volume compaction and/or volume expansion, take place at the portion of the glass substrate irradiated with the high energy beams thereby to induce a stress due to the structural change of constituting material of the glass substrate in the vicinity of such a portion. Any kind of light or electromagnetic waves with any wavelengths, electron beams, neutron beams or γ-rays may be employed.

As the high energy beams to be used in the present invention, it is preferred to employ light having a high photon energy having a wavelength of at most 350 nm in order to let a stress be induced at the irradiated portion. More preferably, the wavelength of the high energy beams is at most 250 nm.

Specific examples of the high energy beams useful in the present invention include, as lights having a high photon energy with a wavelengths of at most 350 nm, XeCl excimer laser (wavelength: 308 nm), 4th harmonic YAG:Nd laser (wavelength: 266 nm), low pressure mercury lamp (wavelength: 254 nm), KrF excimer laser (wavelength: 248 nm), ArF excimer laser (wavelength: 193 nm), high pressure mercury lamp (wavelength: 185 nm), $Xe_2$ excimer lamp (wavelength: 172 nm) and $F_2$ laser (wavelength: 157 nm), and, as electromagnetic waves with short wavelengths, X-rays and γ-rays. Further, as the high energy beams, electron beams or neutron beams may also be employed.

Among the above examples, it is preferred to employ as lights having a high photon energy, KrF excimer laser, ArF excimer laser or $F_2$ laser, from such a viewpoint that a small irradiation spot diameter can be obtained, the stability of the light source is good, and the stress can effectively be induced in the glass substrate. For similar reasons, it is preferred to employ soft X-rays, electron beams or neutron beams. Especially, electron beams are suitable for the irradiation apparatus of the present invention, since electron beams with a very small spot diameter can be applied with a positional precision of at most 15 nm by using an electron beam writer which is used as an apparatus for writing a photomask pattern.

In a case where laser beams are used as the high energy beams, the oscillation form is not particularly limited, and it may be a continuous wave laser (CW laser) or pulse oscillation laser. When continuous wave laser beams are to be used, in order to prevent an excessive rise of the temperature of the portion of the glass substrate surface irradiated with the laser beams, the laser beams may be applied intermittently in such an irradiation cycle of e.g. irradiation for 0.1 second, followed by stopping irradiation for 0.05 second.

As mentioned above, according to the present invention, it is possible to etch only the vicinity of the portion where a contaminant is present relatively more, without substantially etching the entire surface of the glass substrate, whereby the contaminant present on the glass substrate surface can efficiently be removed without increasing the surface roughness of the glass substrate over the entire surface of the substrate. The vicinity of the portion irradiated with the high energy beams will be etched more than at non-irradiated portions, and a recess will be formed when the contaminant is removed in the step (2).

A preferred irradiation condition of the high energy beams at the portion of the glass substrate surface to be irradiated varies depending upon the combination of the high energy beams to be employed and the glass material constituting the glass substrate. Namely, the preferred irradiation condition of the high energy beams is so determined that the increase in the surface roughness by wet-etching at the portion (non-irradiated portion) of the glass substrate surface not irradiated with the high energy beams is at most 0.1 nm (RMS), and that the depth of the recess formed at the irradiated portion after removal of the contaminant by etching is at most 5 nm, particularly preferably at most 2 nm, and that the size of the recess is smaller than the allowable contaminant size in the exposure process.

A preferred irradiation energy density (W/cm$^2$) of the high energy beams at the portion of the glass substrate surface to be irradiated, varies depending upon the type of the high energy beams to be employed and is suitably selected.

In a case where pulse oscillation laser beams are employed as the high energy beams, and the glass material constituting the glass substrate is synthetic quartz glass, preferred irradiation conditions at the portion to be irradiated i.e. preferred ranges of the energy density and the number of the irradiation pulses are, for example, as follows. The range of the preferred energy density depends on light to be used, and in general, with light having a high photon energy (light having a short wavelength), it is possible to effectively bring about the structural change to the glass substrate with a lower energy density.

KrF excimer laser: energy density: at least 20 mJ/(cm$^2$·pulse), more preferably from 100 to 1,000 mJ/(cm$^2$·pulse), number of irradiation pulses: $1 \times 10^6$ to $1 \times 10^7$ pulses, frequency: 10 Hz to 10 kHz.

ArF excimer laser: energy density: at least 2 mJ/(cm$^2$·pulse), more preferably from 10 to 200 mj/(cm$^2$·pulse), number of irradiation pulses: $1 \times 10^6$ to $1 \times 10^7$ pulses, frequency: 10 Hz to 10 kHz.

$F_2$ laser: energy density: at least 1 mJ/(cm$^2$·pulse), more preferably from 5 to 100 mJ/(cm$^2$·pulse), number of irradiation pulses: $1 \times 10^5$ to $5 \times 10^6$ pulses, frequency: 10 Hz to 10 kHz.

In a case where electron beams are used as the high energy beams and the glass material constituting the glass substrate is synthetic quartz glass, preferred ranges of the irradiation conditions at the portion to be irradiated, are, for example, as follows.

Electron beams: acceleration voltage: 5 to 100 keV, current density: 0.001 to 50 mA/cm$^2$, electron beam spot diameter: 50 to 100 nm, irradiation time: 0.1 to 100 seconds.

When high energy beams satisfying the above ranges are used, they are sufficient to induce a stress due to a structural change of constituting material of the glass substrate in the vicinity of the irradiated portion and to have only the vicinity of such a portion etched relatively more, and not too much to bring about an excess structural change takes place in the constituting material in the vicinity of the irradiated portion. Hence, there is substantially no adverse effect to the properties of the glass substrate such as optical properties or mechanical strength.

In the present invention, the size of the portion to be irradiated with the high energy beams i.e. the irradiation area, is not particularly limited. However, the structural change of glass caused by irradiation with the high energy beams may present adverse effects to the properties of the glass substrate such as the optical properties or mechanical strength, and further, a recess will be formed in the vicinity of the irradiated portion when removing of the contaminant in the step (2), and accordingly, the irradiation area is preferably as small as possible. On the other hand, if the irradiation area is too small, it is likely that the glass at the portion where the contaminant is adhered to the substrate may not sufficiently be removed by etching, and the contaminant may not be removed from the substrate. Therefore, in the contaminant removal method of the present invention, it is preferred that before carrying out the step (the high energy beam irradiation step) of irradiating a portion of the glass substrate surface with high energy beams to induce a stress due to a structural change of constituting material of the glass substrate at the portion irradiated with the high energy beams, a step of determining the portion of the glass substrate surface where the contaminant is present, and the size thereof, is provided, and the irradiation with the high energy beams in the high energy beam irradiation step, is applied to the portion where the contaminant is present, as determined in such a step, and further, an area $A_{rad}$ to be irradiated with the high energy beams is adjusted to be:

$$0.5\, A_{defect} \leq A_{rad} \leq 2.0\, A_{defect}$$

where $A_{defect}$ is the area of the contaminant present on the glass substrate surface, and $A_{rad}$ is the area to be irradiated with the high energy beams. If the area $A_{rad}$ to be irradiated with the high energy beams in the step (1) is smaller than $0.5\, A_{defect}$, the portion where the contaminant is adhered to the substrate cannot be sufficiently etched, and the contaminant cannot be removed from the substrate, in the subsequent step (2). Further, if the area $A_{rad}$ to be irradiated with the high energy beam in the step (1) is larger than $2.0\, A_{defect}$, although the portion where the contaminant is adhered with the substrate can be sufficiently etched, and the contaminant can be removed from the substrate in the subsequent step (2), a recess will be formed in the vicinity of the region where the contaminant was present, after removal of the contaminant, such being undesirable.

Here, the area $A_{defect}$ of the contaminant is most preferably the area of the contact portion between the contaminant and the substrate, but such an area is practically very difficult to measure. Therefore, by using e.g. an atomic force microscope (AFM) or a scanning electron microscope (SEM), the maximum area of the contaminant is obtained as observed from right above the substrate, and it can be taken as $A_{defect}$. Further, as a method for obtaining $A_{defect}$, it is also possible to employ another method wherein the area $A_{defect}$ of the contaminant obtained from the contaminant size determined by a defect inspection tool, may be employed. In such a case, the area $A_{defect}$ of the contaminant is obtained by firstly obtaining the diameter of the contaminant as estimated as a polystyrene latex particle (hereinafter referred to as the PSL-equivalent diameter) $D_{PSL}$ and then obtaining it by the following formula:

$$A_{defect} = \pi D_{PSL}^{2}/4$$

Here, the PSL-equivalent diameter $D_{PSL}$ of the contaminant is obtained from the relation between the size measured by a defect inspection tool obtained by measuring a polystyrene latex particle of a known size by the defect inspection tool and the diameter of the same particle.

Namely, in the method of the present invention for removing a contaminant from a glass substrate surface, it is preferred that before carrying out the step (1) (high energy beam irradiation. step) and the step (2) (wet-etching step), a step of determining the portion where the contaminant is present in the glass substrate surface, and the size thereof, is provided, and the irradiation with high energy beams in the high energy beam irradiation step, is applied to the portion where the contaminant is present, as determined in such a step. By taking such a construction, it is possible to effectively remove the contaminant present on the substrate surface without increasing the surface roughness of the glass substrate over the entire surface of the substrate.

Further, here, the irradiation spot diameter of the high energy beams is required to be the same or smaller than the above irradiation area $A_{rad}$. When the irradiation spot diameter of the high energy beams is smaller than the irradiation area $A_{rad}$, irradiation may be carried out while the area to be irradiated i.e. the portion corresponding to the above irradiation area $A_{rad}$, is scanned. The minimum irradiation spot diameter of the high energy beams is in a close relation with the type of the light source, and it is necessary to properly select the type of the high energy beams depending upon the irradiation area $A_{rad}$. Specifically, in a case where the irradiation area $A_{rad}$ is at least about 49,000 nm$^2$ (corresponding to an area of a circle with a diameter of at least 250 nm), KrF excimer laser beams with a wavelength of 248 nm may be used, and in a case where the irradiation area is within a range of from 29,000 to 49,000 nm$^2$ (corresponding to an area of a circle with a diameter of from 190 to 250 nm), ArF excimer laser beams with a wavelength of 193 nm may be employed, and in a case where the irradiation area is within a range of from 17,000 to 29,000 nm$^2$ (corresponding to an area of a circle with a diameter of from 150 to 190 nm), $F_2$ laser beams with a wavelength of 157 nm may be employed. In a case where the irradiation area $A_{rad}$ is smaller than 17,000 nm$^2$ (corresponding to an area of a circle with a diameter of 150 nm), electron beams or soft X-rays may, for example, be employed, whereby the irradiation spot diameter can be reduced to a level of at most 150 nm.

Further, the high energy beams may be applied from the front surface side which is the side of the glass substrate where the contaminant is present, or they may be applied from the rear surface side. Further, the high energy beams may be parallel light or converged light focused at the vicinity of the portion of the substrate surface where the contaminant is present.

In a case where absorption of the high energy beams by the glass substrate is high i.e. the absorption coefficient by the glass substrate at a wavelength of the high energy beams is at least 0.5/cm, it is preferred to apply the high energy beams from the side where the contaminant is present, i.e. from the front surface side. As such a combination, a case may be mentioned wherein as the glass substrate, a synthetic quartz glass substrate is employed, and as the high energy beams, X-rays including soft X-rays, electron beams or, γ-rays are used. Such a combination is preferred, since the substrate material itself has a very high absorption of such high energy beams, and the structural change and the stress thereby caused are limited to only the vicinity of the irradiated substrate surface.

Further, in a case where the high energy beams are applied from the front surface side to the portion of the substrate surface where the contaminant is present, the high energy beams may be applied perpendicularly to the surface, or obliquely.

Further, in a case where absorption of the high energy beams by the glass substrate, particularly the light absorption coefficient before irradiation with the high energy beams (hereinafter referred to as the initial light absorption coefficient) is small at a level of less than 0.5/cm, the high energy beams may be applied from the front surface side or from the rear surface side. If irradiation is applied from a rear surface side to a glass substrate having an initial light absorption coefficient of at least 0.5/cm, it is likely that the high energy beams will be absorbed by the substrate itself before they reach the surface on which the contaminant to be removed is present, whereby no adequate energy can be applied to the portion to be irradiated, or a structural change may be caused at a portion other than the portion to be irradiated. In the case of a glass substrate made of synthetic quartz glass, high energy beams having wavelengths of at least 150 nm, such as $F_2$ laser, ArF excimer laser or KrF excimer laser, may be applied from either side of the front surface side or the rear surface side.

When irradiation is applied from the rear surface side, it is unnecessary to consider light transmittance of the contaminant, and therefore, the choice of the high energy beams to be used will be extended. Further, when converged light is employed as the high energy beams, the irradiation energy density at a portion other than the portion where the contaminant is present, will be low, whereby the structural change at the portion other than the portion where the contaminant is present can be minimized. Thus, the portion where the stress will be induced, is limited only at the vicinity of the portion where the contaminant is present, and a damage of the substrate is thereby reduced, such being desirable.

Further, in a case where high energy beams having wavelengths of at least 150 nm, such as $F_2$ laser, ArF excimer laser or KrF excimer laser, are used as the high energy beams to a glass substrate made of synthetic quartz glass, such high energy beams may be applied from both the front surface side where the contaminant is present and the rear surface side on the opposite side, so that the irradiation intensity at the portion where the contaminant is present, will be from 1 to 1,000 mJ/(pulse·cm$^2$).

After carrying out the step (2), small recesses and/or local roughness may sometimes be observed in the vicinity of the portion where the contaminant was present. However, they are local ones, and by properly selecting the irradiation conditions with high energy beams at the time of carrying out the step (1), defects formed in the vicinity of the portion where the contaminant was present, can be reduced to a level where there will be no problem for the subsequent application of the glass substrate. Accordingly, it is possible to avoid a problem in the subsequent application of the glass substrate.

In a case where high energy beams which will be highly absorbed by the substrate, such as electron beams or X-rays including soft X-rays, are used, if applied from the front surface side where the contaminant is present, the high energy beams will be almost all absorbed in the vicinity of the surface of the substrate to induce a stress by a structural change and thereby to form a portion where the etching rate is high, in the vicinity of the surface. Therefore, in the subsequent etching process, an increase in the surface roughness on the substrate surface after removal of the contaminant can be suppressed to a level of at most 0.1 nm. For example, by applying electron beams to a synthetic quartz glass substrate from its front surface side at an acceleration voltage ranged from 5 to 20 kV at a current density of 10 mA with an irradiation spot diameter of 100 nm for 5 seconds, it is possible to remove the contaminant, and it is possible to suppress the surface damage after removal of the contaminant to a level which is no problematic level, for example, as an EUV lithography mask. Or, by applying ArF excimer laser having an irradiation spot diameter focused in a circular shape with a diameter of 200 nm to a synthetic quartz glass substrate from its front surface side with an energy density of at least $2\,mJ/(cm^2{\cdot}pulse)$, more preferably ranged from 10 to 50 $mJ/(cm^2{\cdot}pulse)$ in a number of irradiation pulses ranged from $1{\times}10^6$ to $1{\times}10^7$ pulses, it is possible to remove the contaminant, and it is possible to suppress the surface damage after removal of the contaminant to a no problematic level, for example, as an EUV lithography mask.

In the present invention, the etchant to be used in the step (2) is not particularly limited so long as it is one suitable for wet-etching treatment of a glass substrate surface, and it can be selected widely from ones known as etchants for wet-etching treatment of glass, particularly as etchants for wet-etching treatment of quartz glass. A specific example of the etchant to be used in the step (2) may be an aqueous hydrogen fluoride (HF) solution, an aqueous ammonium fluoride ($NH_4F$) solution, or an aqueous alkaline solution such as an aqueous ammonia ($NH_4OH$) solution, an aqueous potassium hydroxide (KOH) solution or an aqueous sodium hydroxide (NaOH) solution.

Among the above etchants, it is preferred to employ an aqueous hydrogen fluoride solution or an aqueous ammonia solution, whereby a reagent having a low particle concentration in the liquid and having a low impurity concentration, is readily available. In a case where an aqueous hydrogen fluoride solution is used, it is preferred to carry out etching at a concentration of from 0.1 to 1 wt% at room temperature. Whereas, in a case where an aqueous ammonia solution is used, it is preferred to carry out etching at a concentration of from 0.1 to 2 wt% at room temperature.

When the method of the present invention is employed, a contaminant which is difficult to remove by conventional wet-cleaning or dry cleaning can be removed from a substrate surface, and accordingly, it is possible to effectively remove an inorganic type contaminant firmly adhered to a glass substrate surface, on which dissolution of the contaminant itself is difficult. Here, conventional wet-cleaning means a cleaning method wherein a substrate is exposed to a reagent liquid such as a mixed solution of sulfuric acid and aqueous hydrogen peroxide, aqueous ammonia or deionized water having a surfactant added to remove the contaminant from the substrate surface by utilizing the corrosiveness or reactivity of such a reagent liquid. In such a case, it is common to use a mechanical force such as megasonic, high pressure spray or stirring, in combination. Further, as dry cleaning, a method of decomposition and removal of a contaminant by irradiation with ultraviolet light (e.g. low pressure mercury lamp) or vacuum ultraviolet light (such as a xenon excimer lamp) in an atmosphere containing oxygen, or a method of removing a contaminant by a $CO_2$ aerosol or an Ar aerosol to the substrate surface, is, for example, known.

In a case where an organic type contaminant or residue is present on a glass substrate surface, only the method of the present invention may be employed, but, for example, the method of the present invention may be followed by a conventional cleaning method for cleaning. Otherwise, a contaminant adhered to a substrate may firstly be cleaned by a common method, and then, the method of the present invention may be applied. Such a common cleaning method may, for example, be wet-cleaning employing various cleaning liquids such as a SPM cleaning liquid (a mixed aqueous solution of concentrated hydrochloric acid and aqueous hydrogen peroxide), a SOM cleaning liquid (a mixed aqueous solution of concentrated sulfuric acid and ozonated water), a SCl cleaning liquid (a mixed aqueous solution of an aqueous hydrogen peroxide solution and an aqueous ammonium hydroxide solution, ozonated water (ozone concentration: 5 to 200 ppm) or hydrogenated water (hydrogen concentration: 0.5 to 3 ppm), or dry cleaning employing UV light or vacuum ultraviolet (VUV) light and $O_2$. In the case of wet-cleaning, it is possible to enhance the wet-cleaning by a method of e.g. applying ultrasonic waves such as megasonic or ultrasonic to the reagent liquid or blowing the reagent liquid to the substrate under high pressure.

The present invention is used for the purpose of removing, mainly from a glass substrate for a photomask, a contaminant present on the substrate surface. The glass substrate to which the cleaning method of the present invention is applicable, may, for example, be preferably alkali-free glass, fused quartz glass, synthetic quartz glass, a dopant-doped low thermal expansion synthetic quartz glass or low thermal expansion glass ceramics.

The substrate for a reflection type mask to be used for lithography employing EUV light (hereinafter referred to as an EUVL substrate) is required to have a low thermal expansion property so as not to undergo a dimensional change due to a temperature rise by absorption of the EUV light, to be highly flat without surface undulation, to have small surface roughness and to be free from adherence of a contaminant. The method of the present invention for removing a contaminant present on a substrate surface is useful for such an EUVL substrate. Specifically, the EUVL substrate may, for example, be $TiO_2$- or $SnO_2$-doped low thermal expansion synthetic quartz glass processed to have a highly flat surface and have a small surface roughness, or glass ceramics having $Li_2O$-$Al_2O_3$-$SiO_2$ type fine crystals precipitated.

Now, the method for cleaning a substrate of the present invention will be described with reference to Examples 1 and 2, but it should be understood that the method for cleaning a substrate of the present invention is by no means restricted to the following Examples.

EXAMPLE 1

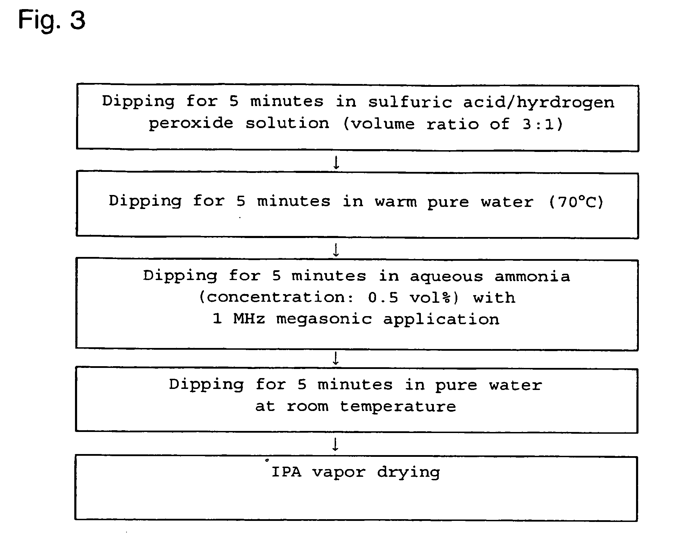

A substrate having a thickness of about 6.6 mm is sliced by a slicing machine with an internal diameter blade from a center portion in the longitudinal direction of a synthetic quartz glass block (size: $155 \times 155 \times 300$ mm) obtained by flame hydrolysis of silicon tetrachloride and subsequent transparent vitrification, and the sliced substrate is set on a grinding device, and both sides of the substrate are ground over the entire surface by using SiC abrasive grains having an average grain diameter of from 10 to 20 $\mu$m and $Al_2O_3$ abrasive grains having an average grain diameter of from 5 to 10 $\mu$m sequentially. Then, the ground substrate is set on a polishing machine and polished until the surface roughness becomes about 0.5 nm (RMS) by using a polyurethane pad as a polishing pad and cerium oxide abrasive grains having an average grain diameter of from 1 to 2 $\mu$m as polishing abrasive grains. Further, by using a polyurethane pad and silicon oxide abrasive grains having an average abrasive grain diameter of from 20 to 30 nm, the substrate is polished by a polishing device until the surface roughness becomes about 0.1 nm (RMS). Here, all steps of polishing et seq are carried out in a cleaning atmosphere of at most class 100. A substrate (size: 152x152x6.35 mm) thus obtained is subjected to clean and drying by means of a batch type cleaning machine by the procedure as shown in Fig. 3. In the cleaning process shown in Fig. 3, the increase in the surface roughness of the synthetic quartz glass surface is less than the detectable limit (less than 0.01 nm (RMS)). Then, the cleaned substrate surface is examined by means of a defect inspection tool (M1350 manufactured by Lasertec Corporation, the lower limit of the detectable size of a contaminant: 60 nm as PSL-equivalent diameter) to identify the location of a defect having a contaminant adhered, which is not removed by the above cleaning and the size thereof.

To the portion where the defect identified as described above, is present, ArF excimer laser is irradiated from the front surface side of the substrate with an energy density of 100 mJ/(cm$^2$·pulse) at 2 kHz with $1 \times 10^5$ pulses. Then, the substrate is dipped in a 0.2 wt% HF aqueous solution of SLSI grade at room temperature for 3 minutes, and further, to remove particles deposited at that time, the substrate is again cleaned by the procedure as shown in Fig. 3 by means of a single mask cleaner.

By carrying out cleaning of the substrate by the foregoing steps, it is possible to obtain a synthetic quartz glass substrate having no contaminant larger than 60 nm as PSL-equivalent diameter. Further, the synthetic quartz glass substrate is etched selectively and locally more at the irradiated portion with a dilute HF solution at a level of 0.2 wt%, whereby an increase in the surface roughness (RMS) over the entire surface of the substrate by the series of cleaning process is at most 0.03 nm. Namely, it is possible to remove from the substrate surface a defect which cannot be removed by conventional cleaning, while the increase of the entire surface roughness (RMS) of the substrate surface is suppressed to a level of at most 0.05 nm. Further, no formation of a recess larger than 60 nm as PSL-equivalent diameter by the series of cleaning process, is detected.

EXAMPLE 2

The surface of a synthetic quartz glass substrate prepared in the same manner as in Example 1, polished until the surface roughness becomes about 0.1 nm (RMS) and cleaned in the procedure as shown in Fig. 3, is inspected by means of a defect inspection tool to identify the location of a defect where a contaminant is adhered, which was not removed by the above cleaning, and the size thereof. To the site where a defect (PSL-equivalent diameter: 60 nm) is present, electron beams (acceleration voltage: 50 keV, current density: 10 mA/cm$^2$, electron beam spot diameter: 50 nm) are applied from the upper surface of the substrate for 5 seconds, and then the substrate is dipped in a 0.2 wt% HF aqueous solution at room temperature for 3 minutes. Then, to remove particles deposited at that time, the substrate is cleaned again in the procedure as shown in Fig. 3. Here, all of the foregoing steps are carried out in a clean atmosphere of at most class 100.

By cleaning the substrate by the foregoing steps, it is possible to obtain a synthetic quartz glass substrate having no contaminant larger than 60 nm as PSL-equivalent diameter. Further, the substrate is etched selectively and locally more at the irradiated portion with a dilute HF solution at a level of 0.2 wt%, whereby an increase in the surface roughness (RMS) of the entire surface of the substrate by the series of cleaning process is 0.03 nm. Namely, it is possible to remove from the substrate surface a defect which cannot be removed by conventional cleaning, while the increase in the entire surface roughness (RMS) of the substrate surface is suppressed to a level of at most 0.05 nm. Further, no formation of a recess larger than 60 nm as PSL-equivalent diameter by the series of cleaning process, is detected.

When the method for cleaning a substrate of the present invention is employed, it is possible to remove a contaminant firmly adhered to the surface of a glass substrate without increasing the surface roughness of the substrate over the entire surface of the substrate and it is possible to realize a surface condition such that the surface has substantially no defect having a contaminant with a size exceeding from 20 to 30 nm and the surface roughness is at most 0.15 nm (RMS). Accordingly, it is particularly useful as a cleaning method for a glass substrate to be used for a reflective mask for EUV lithography.

## Claims

1. A method for removing a contaminant from a surface of a glass substrate, which comprises a step of irradiating a portion of the glass substrate surface where the contaminant is present, with at least one type of high energy beams selected from the group consisting of laser beams having a wavelength of at most 350 nm, X-rays, electron beams, neutron beams and γ-rays, to induce a stress due to a structural change of constituting material of the glass substrate at the portion irradiated with the high energy beams, and a step of wet-etching the glass substrate surface after the irradiation with the high energy beams.

2. The method for removing a contaminant from a surface of a glass substrate according to Claim 1, wherein an etchant used in the step of wet-etching the glass substrate surface, contains at least one member selected from the group consisting of an aqueous hydrogen fluoride (HF) solution, an aqueous ammonium fluoride ($NH_4F$) solution, an aqueous ammonia ($NH_4OH$) solution, an aqueous potassium hydroxide (KOH) solution and an aqueous sodium hydroxide (NaOH) solution.

3. The method for removing a contaminant from a surface of a glass substrate according to Claim 1 or 2, wherein the glass substrate is made of glass selected from the group consisting of alkali-free glass, fused quartz glass, synthetic quartz glass, Ti-doped quartz glass and low thermal expansion glass ceramics.

4. The method for removing a contaminant from a surface of a glass substrate according to any one of Claims 1 to 3, wherein before carrying out the step (the high energy beam irradiation step) of irradiating a portion of the glass substrate surface with high energy beams to induce a stress due to a structural change of constituting material of the glass substrate at the portion irradiated with the high energy beams, a step of determining the portion of the glass substrate surface where the contaminant is present, and the size thereof, is provided, and the irradiation with the high energy beams in the high energy beam irradiation step, is applied to the portion where the contaminant is present, as determined in such a step.

## Patentansprüche

1. Verfahren zum Entfernen eines Fremdstoffes von einer Oberfläche eines Glassubstrates, welches einen Schritt des Bestrahlens eines Bereichs der Glassubstratoberfläche, wo der Fremdstoff vorhanden ist, mit mindestens einem Typ energiereicher Strahlen, ausgewählt aus der Gruppe, bestehend aus Laserstrahlen mit einer Wellenlänge von höchstens 350 nm, Röntgenstrahlen, Elektronenstrahlen, Neutronenstrahlen und γ-Strahlen, um aufgrund einer Strukturänderung des konstitutiven Materials des Glassubstrates in dem mit den energiereichen Strahlen bestrahlten Bereich, eine Spannung zu erzeugen, und einen Schritt des Nassätzens der Glassubstratoberfläche nach der Bestrahlung mit den energiereichen Strahlen umfasst.

2. Verfahren zum Entfernen eines Fremdstoffes von einer Oberfläche eines Glassubstrates nach Anspruch 1, wobei ein Ätzmittel, verwendet im Schritt des Nassätzens der Glassubstratoberfläche, mindestens ein Mitglied enthält, ausgewählt aus der Gruppe, bestehend aus einer wässrigen Wasserstofffluoridlösung (HF), einer wässrigen Ammoniumfluoridlösung ($NH_4F$), einer wässrigen Ammoniaklösung ($NH_4OH$), einer wässrigen Kaliumhydroxidlösung (KOH) und einer wässrigen Natriumhydroxidlösung (NaOH).

3. Verfahren zum Entfernen eines Fremdstoffes von einer Oberfläche eines Glassubstrates nach Anspruch 1 oder 2, wobei das Glassubstrat aus Glas hergestellt ist, ausgewählt aus der Gruppe, bestehend aus alkalifreiem Glas, geschmolzenem Quarzglas, synthetischem Quarzglas, Ti-dotiertem Quarzglas und Glaskeramiken mit geringer Wärmeausdehnung.

4. Verfahren zum Entfernen eines Fremdstoffes von einer Oberfläche eines Glassubstrates nach einem der Ansprüche 1 bis 3, wobei bevor der Schritt des Bestrahlens eines Bereichs der Glassubstratoberfläche mit energiereichen Strahlen (der Bestrahlungsschritt mit energiereichem Strahl), um aufgrund einer Strukturänderung des konstitutiven Materials des Glassubstrates in dem mit den energiereichen Strahlen bestrahlten Bereich, eine Spannung zu erzeugen, durchgeführt wird, ein Schritt des Bestimmens des Bereichs der Glassubstratoberfläche, wo der Fremdstoff vorhanden ist, und der Größe davon bereitgestellt wird und die Bestrahlung mit den energiereichen Strahlen in dem Bestrahlungsschritt mit energiereichem Strahl in dem Bereich angewendet wird, wo der Fremdstoff vorhanden ist, wie in einem solchen Schritt bestimmt.

**Revendications**

1. Procédé pour retirer un contaminant d'une surface d'un substrat de verre, qui comprend une étape d'irradiation d'une partie de la surface du substrat de verre où le contaminant est présent, avec au moins un type de faisceaux à haute énergie choisi parmi le groupe constitué de faisceaux laser présentant une longueur d'onde d'au plus 350 nm, de rayons X, de faisceaux d'électrons, de faisceaux de neutrons et de rayons y, pour induire une contrainte due à un changement structurel de la matière constitutive du substrat de verre au niveau de la partie irradiée avec les faisceaux à haute énergie, et une étape de gravure humide de la surface du substrat de verre après l'irradiation avec les faisceaux à haute énergie.

2. Procédé pour retirer un contaminant d'une surface d'un substrat de verre selon la revendication 1, dans lequel un agent de gravure utilisé à l'étape de gravure humide de la surface du substrat de verre, contient au moins un élément choisi parmi le groupe constitué d'une solution aqueuse de fluorure d'hydrogène (HF), d'une solution aqueuse de fluorure d'ammonium ($NH_4F$), d'une solution aqueuse d'ammoniaque ($NH_4OH$), d'une solution aqueuse d'hydroxyde de potassium (KOH) et d'une solution aqueuse d'hydroxyde de sodium (NaOH).

3. Procédé pour retirer un contaminant d'une surface d'un substrat de verre selon la revendication 1 ou 2, dans lequel le substrat de verre est constitué d'un verre choisi parmi le groupe constitué d'un verre non alcalin, d'un verre de quartz fondu, d'un verre de quartz synthétique, d'un verre de quartz dopé au Ti et d'une vitrocéramique à faible dilatation thermique.

4. Procédé pour retirer un contaminant d'une surface d'un substrat de verre selon l'une quelconque des revendications 1 à 3, dans lequel, avant l'exécution de l'étape (l'étape d'irradiation avec des faisceaux à haute énergie) d'irradiation d'une partie de la surface du substrat de verre avec des faisceaux à haute énergie pour induire une contrainte due à un changement structurel de la matière constitutive du substrat de verre au niveau de la partie irradiée avec les faisceaux à haute énergie, une étape de détermination de la partie de la surface du substrat de verre où le contaminant est présent, et de la taille de celle-ci, est prévue, et l'irradiation avec les faisceaux à haute énergie pendant l'étape d'irradiation avec des faisceaux à haute énergie, est appliquée à la partie où le contaminant est présent, telle que déterminée à cette étape.

## Fig. 1(a)

## Fig. 1(b)

## Fig. 2

# Fig. 3

Dipping for 5 minutes in sulfuric acid/hyrdrogen peroxide solution (volume ratio of 3:1)

↓

Dipping for 5 minutes in warm pure water (70°C)

↓

Dipping for 5 minutes in aqueous ammonia (concentration: 0.5 vol%) with 1 MHz megasonic application

↓

Dipping for 5 minutes in pure water at room temperature

↓

IPA vapor drying

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20070013892 A1
- US 20070163715 A1
- US 20070012335 A1

### Non-patent literature cited in the description

- **V. Kapila et al.** *Proceedings of SPIE - The International Society for Optical Engineering - Photomask Technology,* 2006, vol. 6349 (I
- **M. Hua et al.** Optics and Laser Technology. Elsevier Science, 2004, vol. 37, 9-20